# FASCICULE DE BREVET EUROPEEN

(11) **EP 4 101 006 B1**
(45) Date de publication et mention de la délivrance du brevet: **20.03.2024**
(21) Numéro de dépôt: 21702681.4
(22) Date de dépôt: 04.02.2021
(51) Int. Cl.: H10N 60/12, H10N 60/10, H10N 69/00, G06N 3/065, G06N 10/00

(54) **DISPOSITIF COMPORTANT UN ENSEMBLE DE JONCTIONS JOSEPHSON, SYSTÈME COMPRENANT UN TEL DISPOSITIF ET PROCÉDÉ D'UTILISATION D'UN TEL DISPOSITIF**
VORRICHTUNG MIT EINEM SATZ VON JOSEPHSON-ÜBERGÄNGEN, SYSTEM MIT EINER SOLCHEN VORRICHTUNG UND VERFAHREN ZUR VERWENDUNG EINER SOLCHEN VORRICHTUNG
DEVICE COMPRISING A SET OF JOSEPHSON JUNCTIONS, SYSTEM COMPRISING SUCH A DEVICE AND METHOD FOR USING SUCH A DEVICE

(30) Priorité: 05.02.2020 FR 2001129
(43) Date de publication de la demande: 14.12.2022
(73) Titulaire: THALES, 92400 Courbevoie (FR); Centre national de la recherche scientifique, 75016 Paris (FR); Université Paris-Saclay, 91190 Gif-sur-Yvette (FR)
(72) Inventeur: TRASTOY QUINTELA, Juan, 91767 Palaiseau Cedex (FR); VILLEGAS, Javier E., 92140 Clamart (FR); MARCILHAC, Bruno, 91767 Palaiseau Cedex (FR); SENEOR, Pierre, 75013 Paris (FR); LEMAITRE, Yves, Eric, Jacques, 91767 Palaiseau Cedex (FR); PERCONTE, David, 91767 Palaiseau Cedex (FR); ROUCO GOMEZ, Victor, 91767 Palaiseau Cedex (FR); DLUBAK, Bruno, 92190 Meudon (FR)
(74) Mandataire: Lavoix
(86) Numéro de dépôt international: PCT/EP2021/052682
(87) Numéro de publication internationale: WO 2021/156377

(56) Documents cités:
- EP-A1- 0 823 734
- WO-A1-2008/006217
- WO-A1-2019/173448
- DE-A1- 4 137 953
- US-A1- 2015 317 558
- SCHNEIDER MICHAEL L ET AL: "Energy-Efficient Single-Flux-Quantum Based Neuromorphic Computing", 2017 IEEE INTERNATIONAL CONFERENCE ON REBOOTING COMPUTING (ICRC), IEEE, 8 novembre 2017 (2017-11-08), pages 1-4, XP033273678, DOI: 10.1109/ICRC.2017.8123634

## Description

La présente invention concerne un dispositif comportant un ensemble de jonctions Josephson. La présente invention concerne également un système comprenant un tel dispositif ainsi qu'un procédé d'utilisation d'un tel dispositif.

Les jonctions Josephson comportant des matériaux supraconducteurs sont une composante de nombreux dispositifs électroniques. La supraconductivité est la particularité, pour certains matériaux dits supraconducteurs, de présenter une résistance électrique nulle lorsque leur température est inférieure à une température dite température critique. La supraconductivité est causée par la formation, dans le matériau, de paires de Cooper formées de deux électrons.

Une jonction Josephson est formée par deux supraconducteurs séparés par une barrière non supraconductrice. La barrière est suffisamment fine pour que les paires de Cooper puissent la traverser, et donc transiter d'un supraconducteur à l'autre, par effet tunnel si la couche barrière est isolante électriquement, ou par transport électronique classique dans le cas contraire.

En effet, selon l'effet Josephson, la fonction d'onde des paires de Cooper du premier supraconducteur s'étend à travers la barrière, jusque dans le second supraconducteur où elle interfère avec la fonction d'onde des paires de Cooper du second supraconducteur.

La tension V aux bornes d'une jonction Josephson, et l'intensité I d'un courant traversant la jonction, sont fonction notamment d'un courant critique le caractéristique de la jonction considérée. Ce courant critique le est également fonction de la composante du champ magnétique dans un plan transverse à la direction d'empilement des couches de la jonction Josephson.

Lorsqu'une différence de potentiel fixe est appliquée aux bornes d'une jonction Josephson, il est généré un courant électrique de paires de Cooper sinusoïdal traversant la jonction. La fréquence du courant est fixée par la tension V aux bornes de la jonction. De telles jonctions sont utilisées dans des dispositifs appelés SQUIDs (de l'Anglais « Superconducting QUantum interférence Device »), ainsi que dans des transistors.

Un SQUID est formé par une boucle supraconductrice comportant deux jonctions Josephson disposées en parallèle. De manière connue, les courants électriques circulant dans la boucle sont impactés par tout champ magnétique traversant la boucle, de sorte que la valeur de la tension entre les deux côtés de chaque jonction est modifiée. Ainsi, par une mesure de la tension aux bornes du SQUID, il est possible de déduire la valeur du champ magnétique local, ce qui fait que des SQUIDs sont fréquemment utilisés dans des détecteurs de champ magnétique très sensibles.

Des réseaux de SQUIDs reliés les uns aux autres, nommés SQIFs (de l'Anglais « Superconducting Quantum interférence Filters ») ont en particulier été proposés pour de nombreuses applications, notamment des antennes, du fait de la grande sensibilité des SQUIDs aux champs magnétiques.

En particulier, la tension aux bornes des SQUIDs est une fonction sinusoïdale de la valeur du champ magnétique, ce qui rend complexe l'analyse de cette tension, et requiert l'utilisation de dispositifs spécifiques. Au contraire, puisque de nombreux SQUIDs sont présents dans un seul SQIF, les réponses des SQUIDs individuels tendent à se compenser au-delà d'une valeur de champ magnétique donnée, mais en-deçà de cette valeur la variation de la tension en fonction du champ est monotone. L'analyse de la tension est donc très simple sur une gamme de champs magnétiques centrés sur la valeur zéro.

Toutefois, afin d'optimiser la réponse du SQIF sur cette gamme, il est nécessaire de contrôler très finement les propriétés de chacun des SQUIDs qui composent ce SQIF. En outre, il est difficile de déterminer exactement les propriétés des SQUIDs permettant d'optimiser la réponse du SQIF sur la gamme d'intérêt.

Il est également connu d'autres dispositifs à base de supraconducteurs des documents EP 0 823 734 A1, US 2015/317558 A1, WO 2008/006217 A1, DE 41 37 953A1 et WO 2019/173448 A1 ainsi que de l'article de Michael L. Schneider et al. intitulé « Energy-Efficient Single-Flux-Quantum Based Neuromorphic Computing », IEEE International Conférence on Rebooting Computing (ICRC), doi:10.1 109/ICRC.2017.8123634, p. 1-4, (2017).

Il existe donc un besoin pour un dispositif comportant un ensemble de jonctions Josephson, qui soit mieux contrôlable et plus adaptable que les dispositifs de l'état de la technique.

A cet effet, il est proposé un dispositif comportant un substrat, un ensemble de conducteurs électriques portés par une face du substrat, un ensemble de jonctions portées par ladite face du substrat et un ensemble d'organes de contrôle, chaque conducteur électrique étant réalisé en un matériau supraconducteur, chaque conducteur électrique comprenant une unique première portion s'étendant selon une première direction tangentielle au substrat et un ensemble de deuxièmes portions, les premières portions des conducteurs électriques étant décalées successivement les unes par rapport aux autres selon une deuxième direction perpendiculaire à la première direction, au moins trois jonctions étant interposées selon la deuxième direction entre chaque paire de premières portions successives, chaque jonction étant reliée à la première portion de chacun des conducteurs entre lesquels la jonction est interposée par une deuxième portion dudit conducteur, chaque organe de contrôle étant associé à une unique jonction parmi l'ensemble de jonctions, et étant configuré pour commuter la jonction associée entre une première configuration dans laquelle la jonction forme une jonction Josephson entre les conducteurs auxquels la jonction est reliée et une deuxième configuration dans laquelle la jonction empêche le passage de paires de Cooper entre lesdits conducteurs.

Selon des modes de réalisation particuliers, le dispositif comporte une ou plusieurs des caractéristiques suivantes, prise(s) isolément ou selon toutes les combinaisons techniquement possibles :
- le dispositif comporte au moins dix conducteurs électriques, au moins dix jonctions étant interposées entre chaque paire de premières portions successives.
- chaque deuxième portion s'étend selon la deuxième direction.
- chaque jonction comporte une barrière formant une barrière entre les deux deuxièmes portions reliées à la jonction, au moins une des propriétés suivantes étant vérifiées :
   - la barrière est réalisée en un matériau ferroélectrique présentant une polarisation électrique, l'organe de contrôle étant configuré pour modifier une direction de la polarisation électrique ;
   - la barrière est réalisée en un matériau électriquement isolant, la jonction comportant, en outre, une couche électriquement conductrice présentant une première face en contact avec les deux deuxièmes portions et une deuxième face opposée à la première face, l'organe de contrôle comportant une couche barrière électriquement isolante en contact avec la deuxième face et une électrode de configuration, la couche barrière étant interposée entre la couche électriquement conductrice et l'électrode de configuration, l'organe de contrôle étant configuré pour modifier un potentiel électrique de l'électrode de configuration, la couche électriquement conductrice étant notamment réalisée en graphène ;
   - la jonction comporte au moins deux couches magnétiques, chaque couche magnétique étant réalisée en un matériau magnétique, la jonction étant configurée pour être traversée par un courant électrique traversant la barrière et les deux couches magnétiques, l'organe de contrôle étant configuré pour modifier une orientation d'une aimantation d'au moins une des couches magnétiques.
- le dispositif comporte, en outre, une électrode de sortie, une électrode d'entrée, une alimentation électrique et un capteur, l'alimentation étant propre à injecter un courant électrique dans l'électrode d'entrée et à fixer une intensité du courant électrique à une valeur prédéterminée, le courant électrique traversant chacun des conducteurs depuis l'électrode d'entrée jusqu'à l'électrode de sortie, le capteur étant propre à mesurer une différence de potentiel électrique entre l'électrode d'entrée et l'électrode de sortie.
   - chaque première ou deuxième portion est rectiligne.
   - une distance, mesurée selon la deuxième direction entre les deux premières portions d'une paire de conducteurs successifs, est identique pour chaque paire de conducteurs successifs, et/ou une distance, mesurée selon la première direction entre deux deuxièmes portions successives d'un même conducteur électrique, est identique pour chaque paire de deuxièmes portions successives.

Il est également proposé un système comportant un module de contrôle et un dispositif tel que précédemment décrit, le système étant notamment une antenne.

Selon un mode de réalisation particulier, le module de contrôle est configuré pour :
- déterminer un contour fermé sur la face du substrat portant les conducteurs et les jonctions, le contour fermé délimitant une première zone de ladite face,
- commander une commutation de chaque jonction comprise dans la première zone vers la première configuration correspondante et une commutation de chaque jonction située hors de la première zone vers la deuxième configuration correspondante,
- faire pivoter le contour fermé d'un angle prédéterminé autour d'un axe perpendiculaire à la face du substrat portant les conducteurs et les jonctions, le contour fermé délimitant une deuxième zone à l'issue du pivotement et
- commander une commutation de chaque jonction comprise dans la deuxième zone vers la première configuration correspondante et une commutation de chaque jonction située hors de la deuxième zone vers la deuxième configuration correspondante.

Il est également proposé un procédé d'utilisation d'un dispositif comportant un substrat, un ensemble de conducteurs électriques portés par le substrat, un ensemble de jonctions et un ensemble d'organes de contrôle, chaque conducteur électrique étant réalisé en un matériau supraconducteur, chaque conducteur électrique comprenant une unique première portion s'étendant selon une première direction tangentielle au substrat et un ensemble de deuxièmes portions, les premières portions des conducteurs électriques étant décalées successivement les unes par rapport aux autres selon une deuxième direction perpendiculaire à la première direction, au moins trois jonctions étant interposées selon la deuxième direction entre chaque paire de premières portions successives, chaque jonction étant reliée à la première portion de chacun des conducteurs entre lesquels la jonction est interposée par une deuxième portion dudit conducteur, le procédé comportant une étape de commutation d'au moins une jonction entre une première configuration dans laquelle la jonction forme une jonction Josephson entre les conducteurs auxquels la jonction est reliée et une deuxième configuration dans laquelle la jonction empêche le passage de paires de Cooper entre lesdits conducteurs.

Selon un mode de réalisation particulier, à l'issue de l'étape de commutation, chaque jonction comprise dans une première zone de la face du substrat portant les conducteurs et les jonctions est dans la première configuration, la première zone étant délimitée par un contour fermé sur ladite face, chaque jonction disposée à l'extérieur de la première zone étant dans la deuxième configuration, le procédé comportant, en outre, les étapes suivantes :
- pivotement du contour fermé d'un angle prédéterminé autour d'un axe perpendiculaire à la face du substrat portant les conducteurs et les jonctions, le contour fermé délimitant sur ladite face une deuxième zone après l'étape de pivotement, et
- commutation de chaque jonction comprise dans la deuxième zone vers la première configuration correspondante et commutation de chaque jonction située hors de la deuxième zone vers la deuxième configuration correspondante.

Des caractéristiques et avantages de l'invention apparaîtront à la lecture de la description qui va suivre, donnée uniquement à titre d'exemple non limitatif, et faite en référence aux dessins annexés, sur lesquels :
- la figure 1 est une représentation schématique d'un système comportant un dispositif comprenant un ensemble de jonctions Josephson,
- la figure 2 est une représentation schématique partielle d'un dispositif comprenant un ensemble de jonctions Josephson de la figure 1,
- la figure 3 est un zoom sur la portion III de la figure 2,
- la figure 4 est une représentation schématique du dispositif de la figure 2, dans lequel certaines jonctions Josephson ont été désactivées,
- la figure 5 est un ordinogramme des étapes d'un procédé d'utilisation d'un système de la figure 1,
- la figure 6 est une représentation schématique d'un dispositif comprenant un ensemble de jonctions Josephson selon l'invention, dans un état correspondant à l'une des étapes du procédé de la figure 5
- la figure 7 est une représentation schématique d'un autre exemple de jonction Josephson de la figure 2,
- la figure 8 est une représentation schématique d'un troisième exemple de jonction Josephson de la figure 2, et
- la figure 9 est une représentation schématique d'un quatrième exemple de jonction Josephson de la figure 2.

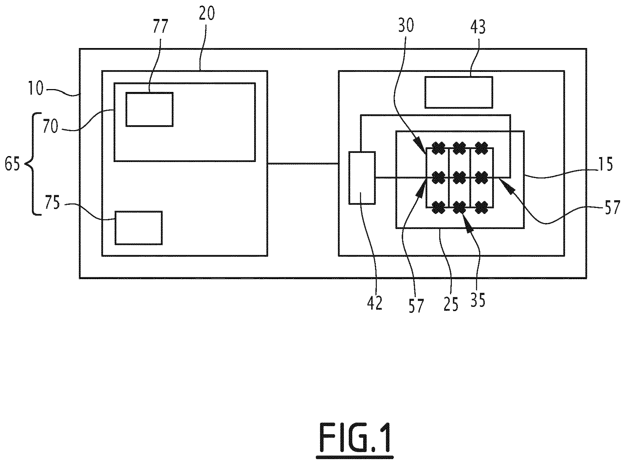

Un premier exemple de système 10 est représenté schématiquement sur la figure 1.

Le système 10 est, par exemple, un système de transmission radiofréquence tel qu'une antenne.

En particulier, le système 10 est propre à émettre et/ou recevoir, notamment à recevoir, des ondes électromagnétiques présentant une fréquence comprise entre zéro et 4 TeraHertz (THz).

En variante, le système 10 est un amplificateur, notamment un amplificateur à bas bruit, un capteur de champ magnétique, un convertisseur analogique-numérique, ou encore un filtre.

Le système 10 comporte un dispositif 15 et un module de contrôle 20.

Le dispositif 15 comprend un substrat 25, un ensemble de conducteurs électriques 30A, 30B, un ensemble de jonctions 35, un ensemble d'organes de contrôle 40, une alimentation électrique 42 et un capteur 43.

Comme il apparaîtra par la suite, les conducteurs électriques 30A, 30B et les jonctions 35 sont propres à former un SQIF comportant un ensemble de SQUIDs reliés les uns aux autres, notamment un réseau bidimensionnel de SQUIDs. En particulier, chaque SQUID est formé par des portions de conducteurs 30A, 30B formant une boucle supraconductrice et par deux jonctions 35 séparant la boucle en deux portions reliées l'une à l'autre par les jonctions 35. Ainsi, les deux jonctions 35 sont connectées en parallèle entre les deux conducteurs 30A, 30B.

Le substrat 25 est prévu pour supporter chaque conducteur électrique 30A, 30B, chaque jonction 35 et chaque organe de contrôle 40.

Le substrat 25 est réalisé en un matériau électriquement isolant tel que le saphir ou l'oxyde de magnésium MgO.

Le substrat 25 présente une face de support 45. La face de support 45 est plane.

Il est notamment défini pour le substrat 25 une direction normale Z, perpendiculaire à la face de support 45. Il est également défini une première direction X et une deuxième direction Y. La première direction X et la deuxième direction Y sont perpendiculaires l'une à l'autre, et perpendiculaires à la direction normale Z.

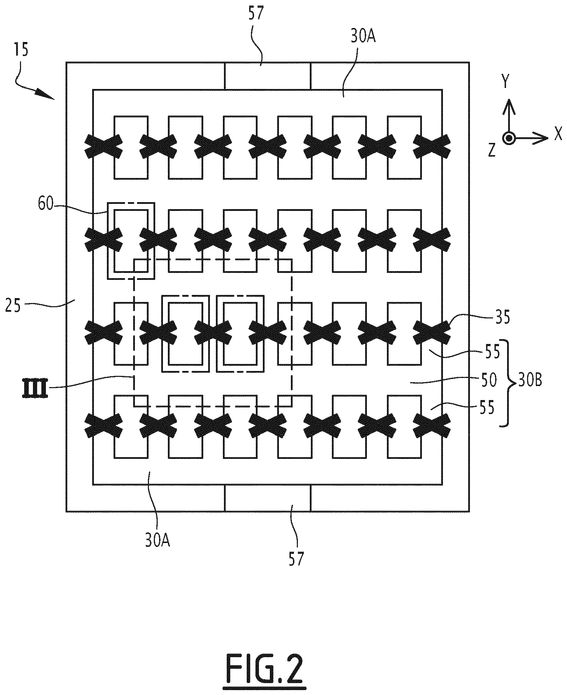

Le nombre de conducteurs 30A, 30B est supérieur ou égal à deux. Selon l'exemple représenté schématiquement sur la figure 2, le dispositif 15 comporte cinq conducteurs 30A, 30B. Toutefois, il est à noter que le nombre de conducteurs 30A, 30B est susceptible de varier, notamment d'être supérieur ou égal à 10, en particulier d'être supérieur ou égal à 100.

L'ensemble de conducteurs 30A, 30B comporte deux conducteurs d'extrémité 30A et au moins un conducteur 30B, notamment une pluralité de conducteurs 30B, interposés entre les deux conducteurs d'extrémité 30A selon la deuxième direction Y. Les conducteurs 30B sont notamment décalés successivement les uns par rapport aux autres selon la deuxième direction Y.

Deux conducteurs 30A, 30B sont dits « successifs » ou « voisins » si aucun autre conducteur 30A, 30B n'est interposé entre les deux conducteurs considérés selon la deuxième direction Y.

Les conducteurs 30A, 30B sont électriquement connectés en série. En particulier, l'ensemble de conducteurs 30A, 30B est configuré pour qu'un courant électrique traverse successivement l'un des conducteurs d'extrémité 30A, chaque conducteur 30B puis l'autre conducteur d'extrémité 30A.

Chaque conducteur 30A, 30B comporte une unique première portion 50 et un ensemble de deuxièmes portions 55.

Chaque conducteur d'extrémité 30A est électriquement connecté à une première électrode 57. Les conducteurs 30A, 30B sont, notamment, interposés selon la deuxième direction Y entre les deux premières électrodes 57.

Chaque conducteur 30A, 30B est réalisé en un premier matériau M1.

Le premier matériau M1 est un matériau supraconducteur.

Le premier matériau M1 présente une première résistivité R1, dépendante de la température.

La résistivité d'un matériau est définie comme étant la résistance électrique d'un tronçon de matériau de 1 mètre (m) de longueur et de 1 m² de section. La résistivité est, généralement, exprimée en ohm·mètre (Ω·m). La résistance électrique mesurée entre deux contacts est définie comme le rapport entre la tension mesurée aux bornes des deux contacts et le courant électrique circulant dans une branche de circuit passant par les deux bornes.

Il est entendu par le terme « matériau supraconducteur » que le premier matériau M1 présente une première température critique Tc1. Lorsque le premier matériau M1 est à une température inférieure ou égale à la première température critique Tc1, la première résistivité R1 est égale à zéro.

La première température critique Tc1 est, notamment, inférieure ou égale à une température de consigne Tc à laquelle le dispositif 15 est destiné à être utilisé.

La concentration de porteurs de charge est définie comme étant la somme des charges électriques de chaque porteur de charge par unité de volume de premier matériau M1.

Le premier matériau M1 est, par exemple, un matériau de la famille des cuprates. Les cuprates sont des composés chimiques contenant des cations cuivre. De nombreux composés de la famille des cuprates présentent les propriétés décrites ci-dessus.

Par exemple, le premier matériau M1 est un oxyde mixte de baryum, de cuivre, et d'yttrium. Les oxydes mixtes de baryum, de cuivre et d'yttrium, également notés YBCO sont des composés chimiques cristallins présentant fréquemment la formule chimique YBa₂Cu₃O_{7-δ}, dans laquelle δ est un nombre réel supérieur ou égal à zéro. De préférence, δ est compris entre 0 et 0,6.

Le premier matériau M1 est, par exemple, NdBaCuO ou LaBaCuO.

Il est à noter que d'autres types de premiers matériaux M1 sont envisageables, par exemple Nb ou NbSn.

La première portion 50 de chaque conducteur 30A, 30B est portée par la face de support 45.

La première portion 50 s'étend, par exemple, selon une direction tangentielle au substrat 25, c'est-à-dire selon une direction perpendiculaire à la direction normale Z. Selon l'exemple représenté sur la figure 2, la première portion 50 de chaque conducteur 30A, 30B s'étend selon la première direction X.

Chaque première portion 50 est, par exemple, rectiligne. En variante, la première portion présente une forme courbe dans un plan perpendiculaire à la direction normale Z, par exemple une forme sinusoïdale autour d'un segment de droite parallèle à la première direction X.

Chaque première portion 50 est, par exemple, une portion d'une couche du premier matériau M1 portée par la face de support 45.

Selon un mode de réalisation, chaque première portion 50 présente une épaisseur, mesurée selon la direction normale Z, comprise entre 30 nanomètres (nm) et 200 nm.

Une largeur de la première portion 50, mesurée par exemple selon la deuxième direction Y, est comprise entre 100 nm et 2 micromètres (µm).

Les premières portions 50 des conducteurs 30A, 30B sont décalées successivement selon la deuxième direction Y les unes par rapport aux autres. Par exemple, chaque première portion 50 s'étend selon une ligne propre, les lignes propres étant parallèles entre elles.

Selon le mode de réalisation représenté sur la figure 2, les premières portions 50 des conducteurs 30A, 30B ne sont pas décalées les unes par rapport aux autres selon la première direction X. Toutefois, des modes de réalisation dans lesquels aux moins deux premières portions 50 successives sont décalées l'une par rapport à l'autre selon la première direction X sont également envisageables.

Une distance entre les lignes propres de deux premières portions 50 successives est, par exemple, comprise entre 300 nm et 10 µm. Selon un mode de réalisation, cette distance est uniforme. En d'autres termes, cette distance est égale pour chaque paire de deux premières portions 50 appartenant à deux conducteurs 30 successifs.

Chaque première portion 50 est distincte des autres premières portions 50, en particulier chaque première portion 50 est distante des autres premières portions 50 Une distance entre deux premières portions 50 successives est, par exemple, comprise entre 300 nm et 10 µm.

Selon un mode de réalisation, les premières portions 50 de chaque paire de premières portions 50 choisies parmi l'ensemble des premières portions 50 des conducteurs 30A, 30B sont superposables l'une à l'autre par une translation selon la deuxième direction Y.

L'ensemble de deuxièmes portions 55 de chaque conducteur 30A, 30B comprend au moins trois deuxièmes portions 55, notamment au moins six deuxièmes portions. Sur le mode de réalisation représenté sur la figure 2, chaque conducteur d'extrémité 30A comporte sept deuxièmes portions 55, et chaque conducteur 30B interposé entre les conducteurs d'extrémité 30A comprend 14 deuxièmes portions.

Il est à noter que le nombre de deuxièmes portions 55 de chaque conducteur 30A, 30B est susceptible de varier, par exemple d'être supérieur ou égal à 10, notamment supérieur ou égal à 100.

Chaque deuxième portion 55 s'étend, par exemple, selon une direction tangentielle au substrat 25. Selon l'exemple représenté sur la figure 2, chaque deuxième portion 55 s'étend selon la deuxième direction Y. Toutefois, des modes de réalisation dans lesquels les deuxièmes portions 55 s'étendent selon une direction différente de la deuxième direction Y sont également envisageables.

Chaque deuxième portion 55 est, par exemple, rectiligne. En variante, la première portion présente une forme courbe dans un plan perpendiculaire à la direction normale Z, par exemple une forme sinusoïdale autour d'un segment de droite parallèle à la deuxième direction Y.

Chaque deuxième portion 55 est, par exemple, une portion d'une couche du premier matériau M1 portée par la face de support 45.

Selon un mode de réalisation, chaque deuxième portion 55 présente une épaisseur, mesurée selon la direction normale Z, comprise entre 30 nm et 200 nm.

Une largeur de chaque deuxième portion 55, mesurée par exemple selon la première direction X, est comprise entre 100 nm et 2 µm.

Chaque deuxième portion 55 s'étend, par exemple selon la deuxième direction Y, à partir de la première portion 50. En particulier, chaque deuxième portion 55 relie la première portion 50 à une jonction 35 interposée entre le conducteur 30A, 30B considéré et un conducteur 30A, 30B voisin de ce conducteur 30A, 30B.

L'ensemble de deuxièmes portions 55 comporte, pour chaque conducteur 30B, un premier sous-ensemble et un deuxième sous-ensemble.

La première portion 50 est interposée selon la deuxième direction Y entre les deux sous-ensembles de deuxièmes portions 55.

En particulier, chaque conducteur 30B étant interposé entre deux conducteurs 30A, 30B voisins du conducteur 30B considéré, chaque deuxième portion 55 du premier sous-ensemble s'étendant à partir de la première portion 50 du conducteur 30B considéré vers l'un des deux conducteurs 30A, 30B voisins, chaque deuxième portion 55 du deuxième sous-ensemble s'étendant vers l'autre des deux conducteurs 30A, 30B voisins du conducteur 30B considéré.

Selon un mode de réalisation, chaque sous-ensemble d'un conducteur 30B comporte un nombre de deuxièmes portions 55 égal au nombre de deuxièmes portions 55 de l'autre sous-ensemble. En particulier, chaque deuxième portion 55 d'un sous-ensemble est alignée selon la direction Y avec une deuxième portion 55 de l'autre sous-ensemble.

Chaque deuxième portion 55 d'un conducteur d'extrémité 30A s'étend selon la deuxième direction Y en direction de l'unique conducteur 30B voisin du conducteur d'extrémité 30A considéré. Ainsi, chaque conducteur d'extrémité 30A comporte un unique sous-ensemble de deuxièmes portions 55.

Les deuxièmes portions 55 d'un même sous-ensemble sont décalées successivement selon la première direction X les unes par rapport aux autres. Par exemple, chaque deuxième portion 55 s'étend selon une ligne propre, les lignes propres étant parallèles entre elles.

Une distance entre les lignes propres de deux deuxièmes portions 55 successives d'un même sous-ensemble est, par exemple, comprise entre 300 nm et 10 µm. Selon un mode de réalisation, cette distance est uniforme. En d'autres termes, cette distance est égale pour chaque paire de deuxièmes portions 55 successives.

Il est notamment entendu par « deux deuxièmes portions 55 successives », deux deuxièmes portions 55 entre lesquelles aucune autre deuxième portion 55 n'est interposée.

Chaque deuxième portion 55 est distincte des autres deuxièmes portions 55, en particulier chaque deuxième portion 55 est distante des autres deuxièmes portions 55. Une distance entre deux deuxièmes portions 55 successives est, par exemple, comprise entre 300 nm et 10 µm.

Ainsi, deux deuxièmes portions 55 successives d'un même conducteur 30A, 30B, reliées à deux jonctions 35, forment une boucle supraconductrice avec les deux deuxièmes portions 55 reliées aux mêmes jonctions 35 d'un conducteur 30A, 30B voisin.

Cette boucle s'étend le long d'une ligne propre fermée 60. La ligne propre fermée 60 s'étend successivement le long d'une première jonction 35, d'une première deuxième portion 55 d'un premier conducteur 30A, 30B, d'une partie de la première portion 50 de ce conducteur 30A, 30B, d'une autre deuxième portion 55 de ce conducteur, d'une deuxième jonction 35, d'une troisième deuxième portion 55 d'un deuxième conducteur 30A, 30B, d'une partie de la première portion 50 de ce conducteur 30A, 30B et d'une quatrième deuxième portion 55 de ce conducteur 30A, 30B pour revenir à la première jonction 35.

En particulier, chaque paire de deuxièmes portions 55 successives d'un même conducteur 30A, 30B fait partie d'une boucle supraconductrice comportant ces deux deuxièmes portions 55. Ainsi, chaque deuxième portion 55 fait partie d'une ou de deux boucles supraconductrices avec la ou les deux deuxième(s) portion(s) 55 voisines.

Chaque deuxième portion 55 présente, notamment, une longueur égale à la longueur de chaque autre deuxième portion 55 qui est interposée entre les mêmes conducteurs 30A, 30B que la deuxième portion 55 considérée. Par exemple, une longueur de chaque deuxième portion 55 est identique à la longueur de chaque autre deuxième portion 55.

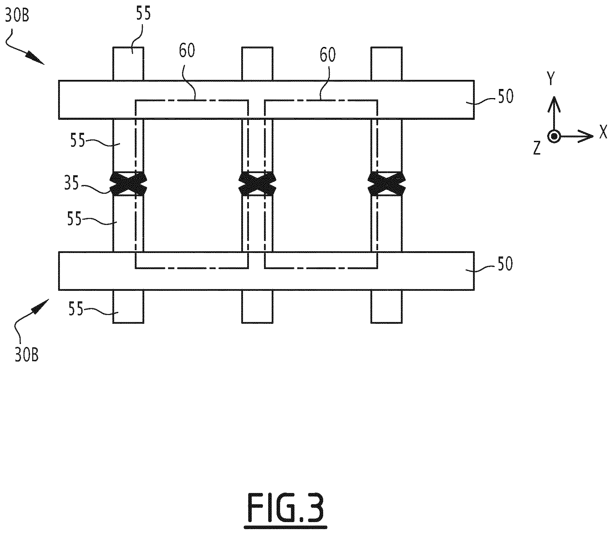

Un détail de la figure 2 est représenté sur la figure 3. On y distingue partiellement deux conducteurs 30B reliés chacun par des deuxièmes portions 55 à des jonctions 35 interposées entre les deux conducteurs 30B considérés. Du fait de la représentation partielle des deux conducteurs 30B, seules trois jonctions 35 et, pour chaque conducteur 30B, six deuxièmes portions 55, sont visibles. Parmi ces six deuxièmes portions 55, trois relient le conducteur 30B considéré aux trois jonctions 35, et trois deuxièmes portions 55, partiellement visibles, s'étendent à l'opposé des jonctions 35.

Ainsi, chaque groupe de deux jonctions 55 successives fait partie d'une boucle supraconductrice comportant deux jonctions 35 et s'étendant le long d'une ligne propre fermée 60.

Selon un mode de réalisation, les deuxièmes portions 55 de chaque sous-ensemble sont superposables l'une à l'autre par une translation selon la première direction X.

L'ensemble de jonctions 35 comprend, pour chaque paire de conducteurs 30A, 30B successifs, au moins trois jonctions 35 interposées entre les conducteurs 30A, 30B considérés selon la deuxième direction Y. En particulier, chaque jonction 35 est interposée entre les premières portions 50 des conducteurs 30A, 30B considérés.

Selon l'exemple représenté sur la figure 2, l'ensemble de jonctions 35 comprend, pour chaque paire de conducteurs 30A, 30B successifs, sept jonctions 35 interposées entre les conducteurs 30A, 30B considérés selon la deuxième direction Y.

Il est à noter que le nombre de jonctions 35 interposées entre chaque paire de conducteurs 30A, 30B successifs est susceptible de varier, notamment d'être supérieur ou égal à 10, en particulier d'être supérieur ou égal à 100.

Plus précisément, chaque jonction 35 est reliée à la première portion 50 de chacun des conducteurs 30A, 30B successifs entre lesquels elle est interposée par une deuxième portion 55 dudit conducteur 30A, 30B. En particulier, la jonction 35 est électriquement connectée aux deux deuxièmes portions 55 correspondantes.

Chaque jonction 35 comporte notamment une barrière 63 interposée entre les deux deuxièmes portions 55 reliées à la jonction 35. La barrière 63 est notamment en contact avec les deux deuxièmes portions 55 qui sont reliées à la jonction 35. La barrière 63 forme alors la troisième partie.

La barrière 63 sera décrite plus en détail plus bas.

Chaque jonction 35 est propre à commuter entre une première configuration et une deuxième configuration.

Sur la figure 2, chaque jonction 35 est dans sa première configuration, représentée symboliquement par une croix.

Lorsqu'elle est dans la première configuration, chaque jonction 35 forme une jonction Josephson entre les deux conducteurs 30A, 30B, notamment entre les deux deuxièmes portions 55 auxquelles la jonction 35 est connectée. En particulier, lorsque la jonction 35 forme une jonction Josephson entre les deux deuxièmes portions 55, la jonction 35 est propre à permettre le transfert de paires de Cooper entre ces deux deuxièmes portions 55.

Par exemple, la jonction 35 est propre à permettre le transfert de paires de Cooper entre les deux deuxièmes portions 55 par conduction électrique. En variante, la jonction 35 est propre à permettre le transfert de paires de Cooper entre les deux deuxièmes portions 55 par effet tunnel.

En particulier, chaque paire de jonctions 35 successives interposées entre deux mêmes conducteurs 30A, 30B, c'est-à-dire chaque paire de jonctions 35 entre lesquelles aucune autre jonction 35 n'est interposée selon la première direction X, forme un SQUID avec les deuxièmes portions 55 auxquelles elles sont reliées et avec les parties des premières portions 50 intercalées entre ces deuxièmes portions 55. Notamment, chaque boucle supraconductrice s'étendant selon une ligne propre fermée 60 forme un SQUID avec les deux jonctions 35 qu'elle comporte.

Lorsqu'elle est dans la deuxième configuration, la jonction 35 empêche le passage de paires de Cooper entre les deux conducteurs 30A, 30B auxquels elle est connectée. En particulier, la jonction 35 empêche le passage de paires de Cooper entre ces deux conducteurs 30A, 30B, notamment entre les deux deuxièmes portions 55 connectées à la jonction 35. La jonction 35 ne forme donc pas une jonction Josephson.

Par exemple, lorsqu'une jonction 35 est dans sa deuxième configuration, la jonction 35 est électriquement conductrice mais n'est pas supraconductrice. Ainsi, la jonction permet le passage d'un courant électrique entre les deux conducteurs 30A, 30B auxquels elle est connectée, mais ne permet pas le passage de paires de Cooper.

En variante, lorsqu'une jonction 35 empêche le passage de paires de Cooper entre les deux conducteurs 30A, 30B auxquels elle est connectée, cette jonction 35 empêche le passage d'un courant électrique entre ces deux conducteurs 30A, 30B. La jonction 35 est alors électriquement isolante.

Chaque organe de contrôle 40 est associé à une jonction 35 correspondante.

Chaque organe de contrôle 40 est configuré pour faire commuter la jonction 35 correspondante entre la première configuration et la deuxième configuration.

Par exemple, chaque organe de contrôle 40 est configuré pour modifier une valeur du courant critique de la jonction 35 associée entre une première valeur et une deuxième valeur. Lorsque le courant critique présente la première valeur, la jonction 35 forme une jonction Josephson lorsque la jonction 35 est à la température de consigne Tc. Lorsque le courant critique présente la deuxième valeur, la jonction 35 ne forme pas une jonction Josephson lorsque la jonction 35 est à la température de consigne Tc.

En variante, chaque organe de contrôle 40 configuré pour faire varier la température critique d'une portion de la jonction 35 entre une première valeur strictement inférieure à la température de consigne Tc et une deuxième valeur strictement supérieure à la température de consigne Tc.

L'alimentation électrique 42 est configurée pour faire circuler un courant électrique entre les deux premières électrodes 57. Le courant électrique est, par exemple, un courant continu.

En particulier, l'alimentation électrique 42 est configurée pour fixer une valeur d'un premier paramètre du courant électrique, notamment l'intensité, à une valeur prédéterminée. En variante, le paramètre est une tension.

Le courant électrique traverse successivement une première électrode 57, le conducteur d'extrémité 30A associé, chaque conducteur 30B, l'autre conducteur d'extrémité 30A puis l'autre première électrode 57.

Le capteur 43 est propre à mesurer une valeur d'un deuxième paramètre du courant électrique, le deuxième paramètre étant distinct du premier paramètre. Le deuxième paramètre est, par exemple, une tension électrique entre les deux premières électrodes 57.

Le module de contrôle 20 est configuré pour commander chaque organe de contrôle 40. Le module de contrôle 20 est, en outre, configuré pour maintenir une température du dispositif 20 à la température de consigne Tc.

Le module de contrôle 20 est, en outre, configuré pour mettre en oeuvre un procédé d'utilisation du dispositif 15.

Le module de contrôle 20 comporte une unité de traitement d'informations 65 comprenant une mémoire 70 et un processeur 75. La mémoire 70 comprend un ensemble d'instructions logicielles 77, mémorisées dans la mémoire 70 et propres à mettre en oeuvre le procédé d'utilisation lorsqu'elles sont exécutées par le processeur 75.

En variante, l'unité de traitement d'informations 65 est susceptible d'être réalisée sous la forme de composants logiques programmables, ou encore de circuits intégrés dédiés.

Le procédé comprend au moins une première étape 200 de commutation. La première étape de commutation 200 comprend la commutation, par le ou les organe(s) de contrôle 40 associé(s), d'au moins une jonction 35 entre sa première configuration et sa deuxième configuration.

Par exemple, la première étape 200 de commutation comprend la commutation d'au moins une jonction 35 depuis sa première configuration jusqu'à sa deuxième configuration. En particulier, le module de contrôle 20 commande la commutation, par le ou les organe(s) de contrôle 40 correspondant(s) d'au moins une jonction 35 depuis sa première configuration jusqu'à sa deuxième configuration.

Chaque jonction 35 dans sa deuxième configuration empêche le passage de paires de Cooper entre les deuxièmes portions 55 reliées à la jonction 35. La jonction 35 ne forme donc pas une jonction Josephson entre ces deuxièmes portions 55.

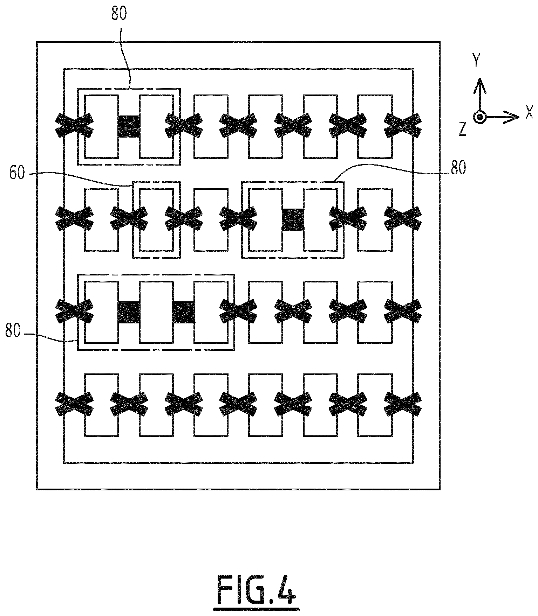

Un exemple du dispositif 15 à l'issue de la première étape de configuration 35 est représenté sur la figure 4, en considérant que le dispositif 15 était, avant la première étape 200 de commutation, dans la configuration représentée sur la figure 2 et dans laquelle chaque jonction 35 formait une jonction Josephson.

Lorsque chaque jonction 35 forme une jonction Josephson, chaque paire de jonctions 35 successives appartient à un SQUID comprenant ces deux jonctions 35, les quatre deuxièmes portions 55 qui y sont reliées et les parties des premières portions 50 comprises entre ces deuxièmes portions 55. Chaque SQUID correspond donc à une boucle supraconductrice s'étendant le long d'une ligne propre fermée 60 qui ne comprend que deux jonctions 35. En particulier, la ligne propre 60 n'entoure aucune autre jonction 35.

Chaque SQUID présente donc une surface égale à la surface délimitée par deux premières portions 50 successives selon la deuxième direction Y et par deux deuxièmes portions 55 successives selon la première direction X.

Afin d'en simplifier la compréhension, seules les lignes propres 60 correspondant à trois SQUIDs sont représentées sur la figure 2, mais il est à noter que chaque paire de jonctions 35 successives forme un SQUID s'étendant selon une ligne propre 60.

Il est considéré, à titre d'exemple, que, lors de la première étape 200 de commutation, quatre des jonctions 35 commutent dans leur deuxième configuration. Ces jonctions 35 sont représentées symboliquement par des carrés afin de les distinguer des autres jonctions 35 qui sont dans leurs premières configurations respectives.

Chacune des jonctions 35 dans leur deuxième configuration ne permet pas le passage de paires de Cooper et ne participe donc pas à la formation d'un SQUID. Toutefois, les jonctions 35 qui sont dans leurs premières configurations respectives et qui encadrent selon la première direction X un groupe d'une ou plusieurs jonctions 35 successives empêchant le passage de paires de Cooper forment un SQUID s'étendant le long d'une ligne propre fermée 80 entourant le groupe de jonctions 35 en question.

Ainsi, sur la figure 4, où un groupe de deux jonctions 35 successives et deux groupes d'une seule jonction 35 ont étés commutés dans les deuxièmes configurations associées, trois SQUIDs associés à des lignes propres 80 sont formés. Les autres SQUIDs correspondant aux jonctions 35 qui n'ont pas été commutées ne sont pas modifiés.

Chaque SQUID associé à une ligne propre 80 présente une surface strictement supérieure aux SQUIDs associés à des lignes propres 60.

Selon un complément facultatif, les jonctions 35 qui doivent être dans leur première configuration et les jonctions 35 qui doivent être dans leur deuxième configuration à l'issue de la première étape de commutation 200 sont sélectionnées par un procédé d'apprentissage profond.

Les procédés d'apprentissage profond (ou « deep learning », selon l'expression anglaise équivalente) sont des procédés d'apprentissage automatique dans lesquels un appareil, notamment le module de contrôle 20, modélise des données avec un haut niveau d'abstraction des données.

Un tel procédé d'apprentissage profond met par exemple en oeuvre un algorithme d'optimisation dans lequel il est défini une fonction de coûts pour le dispositif 15, que le module de contrôle 20 tente de minimiser par rapport à l'application visée pour le système 10.

Les procédés d'apprentissage profond comprennent par exemple la mise en oeuvre d'un réseau de neurones. Un réseau de neurones est en général composé d'une succession de couches dont chacune prend ses entrées sur les sorties de la précédente. Chaque couche est composée d'une pluralité de neurones, prenant leurs entrées sur les neurones de la couche précédente. À chaque synapse entre neurones est associée un poids synaptique, de sorte que les entrées reçues par un neurone sont multipliées par ce poids, puis additionnées par ledit neurone. Le réseau de neurones est optimisé grâce aux ajustements des différents poids synaptiques pendant la phase d'apprentissage.

Puisque le comportement électrique des SQUIDs est une fonction de la surface de chaque SQUID en présence d'un champ magnétique, il est possible de modifier le dispositif 15 par activation ou désactivation (c'est-à-dire commutation vers la première ou la deuxième configuration) des jonctions 35 après que le dispositif 15 ait été fabriqué. Le dispositif 15 est donc mieux contrôlable et plus adaptable que les dispositifs de l'état de la technique.

En outre, le dispositif 15 est moins sensible à d'éventuelles imprécisions dans la fabrication des boucles formant les SQUIDs (imprécisions découlant notamment d'imprécisions dans la fabrication des conducteurs 30A, 30B ou des jonctions 35), puisque les effets de ces imprécisions sont susceptibles d'être compensés par la sélection d'un ensemble adéquat de jonctions 35 à basculer dans leur deuxième configuration.

Lorsque le dispositif 15 comporte au moins dix conducteurs électriques 30A, 30B, au moins dix jonctions 35 étant interposées entre chaque paire de conducteurs 30A, 30B successifs, le dispositif 15 est particulièrement ajustable.

Lorsque chaque deuxième portion 55 s'étend selon la deuxième direction, la conception du dispositif 15, et notamment la conception du ou des masque(s) utilisé(s) pour la fabrication par photolithographie du dispositif 15, est simplifiée, de même lorsque chaque première et deuxième portion 50, 55 est rectiligne. La fabrication est encore simplifiée lorsque la distance entre chaque paire de deuxièmes portions 55 successives est identique pour toutes les paires de deuxièmes portions 55, de même que lorsque la distance entre chaque paire de premières portions 50 successives est identique pour toutes les paires de premières portions 50 successives.

Lorsque l'alimentation 42 est configurée pour imposer une intensité du courant électrique circulant entre les deux conducteurs d'extrémités 30A, et le capteur 43 propre à mesurer une tension électrique entre ces deux conducteurs d'extrémité 30A, le dispositif 15 est avantageusement utilisable comme élément récepteur d'ondes électromagnétiques dans une antenne, puisque la tension dépend du champ magnétique perçu par chaque SQUID.

Selon un mode de mise en oeuvre du procédé d'utilisation, le procédé comprend, en outre, une étape de détermination 210, une étape de pivotement 220 et une deuxième étape de commutation 230. En particulier, l'étape de détermination 210 est suivie successivement de la première étape de commutation 200, de l'étape de pivotement 220 et de la deuxième étape de commutation 230.

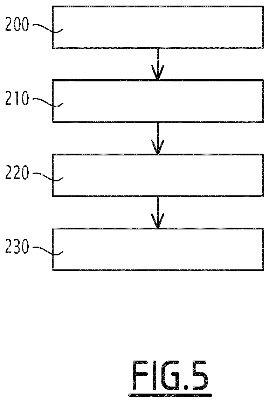

Un ordinogramme des étapes 200 à 230 est représenté sur la figure 5.

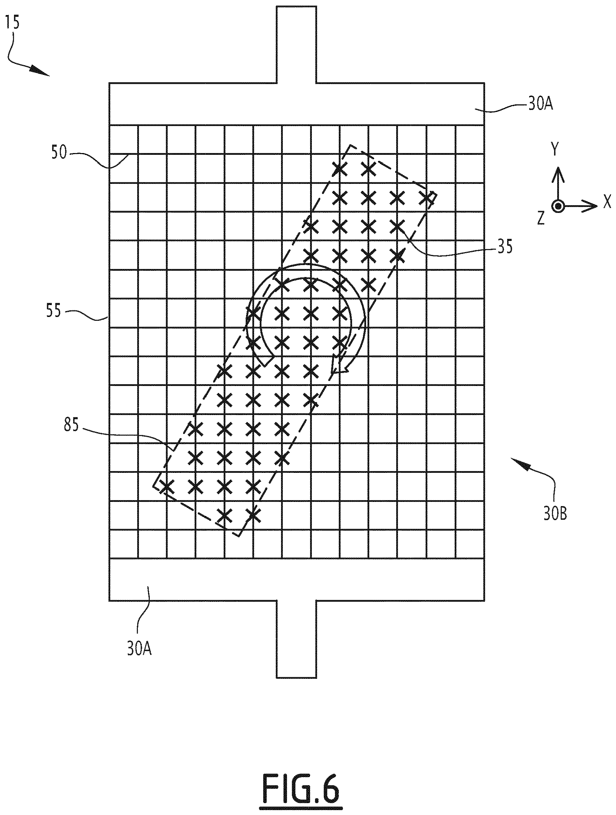

Ce mode de mise en oeuvre est particulièrement adapté à être mis en oeuvre par des dispositifs 15 de grandes dimensions. Par exemple, le fonctionnement de ce mode de mise en oeuvre est représenté sur la figure 6 dans le cas d'un dispositif 15 comportant 16 conducteurs 30A, 30B, comportant chacun 14 (cas des conducteurs 30A) ou 28 (cas des conducteurs 30B) deuxièmes portions 55. Il est à noter que le nombre de conducteurs 30A, 30B et de deuxièmes portions 55 est susceptible de varier.

Sur la figure 6, afin de ne pas surcharger la figure, les premières et deuxièmes portions 50 et 55 sont représentées par des traits fins, à l'exception des premières portions 55 des conducteurs d'extrémité 30A, qui sont représentées par des traits épais.

Lors de l'étape de détermination 210, le module de contrôle 20 détermine un contour fermé 85 sur la face de support 45. Le contour fermé 85 délimite sur cette face 45 une première zone.

Le contour fermé 85 présente une dimension maximale et une dimension minimale mesurées selon des directions perpendiculaires l'une à l'autre, la dimension maximale étant strictement supérieure à la dimension minimale. Le contour fermé 85 est, ainsi, un contour non-circulaire.

Un rapport entre la dimension maximale et la dimension minimale est, par exemple, supérieur ou égal à 3, notamment supérieur ou égal à 5, en particulier supérieur ou égal à 10.

Le contour fermé 85 est, par exemple, rectangulaire, comme représenté sur la figure 6. Dans ce cas, la dimension maximale est la longueur du plus grand côté du rectangle, et la dimension minimale est la longueur du plus petit côté du rectangle.

En variante, le contour fermé 85 est elliptique, auquel cas la dimension maximale est le grand axe de l'ellipse et la dimension minimale est le petit axe de l'ellipse. Toutefois, d'autres formes sont également envisageables.3

Le contour fermé 85 présente une surface comprise entre 10 µm² et 10 centimètres carrés (cm²).

En particulier, le contour fermé 85 entoure un groupe de jonctions 35 comprenant au moins 50 jonctions 35 distinctes.

Au cours de la première étape de commutation 200, le module de contrôle 20 commande la commutation de chaque jonction 35 comprise dans la première zone vers sa première configuration, et commande la commutation de chaque jonction 35 située à l'extérieur de la première zone dans sa deuxième configuration. Sur la figure 6, chaque jonction 35 dans sa première configuration est représentée par une croix, tandis que les jonctions 35 qui sont dans leurs deuxièmes configurations ne sont pas représentées.

Au cours de l'étape de pivotement 220, le module de contrôle 20 fait pivoter le contour fermé 85 autour d'un axe parallèle à la direction normale Z. Cela est représenté symboliquement sur la figure 6 par une flèche.

Par exemple, le module de contrôle 20 fait pivoter le contour fermé 85 d'un angle prédéterminé au cours de l'étape de pivotement 220.

Le contour fermé 85 délimite une deuxième zone distincte de la première zone à l'issue de l'étape de pivotement 220.

Au cours de la deuxième étape de commutation 230, le module de contrôle 20 commande la commutation de chaque jonction 35 comprise dans la deuxième zone vers sa première configuration, et commande la commutation de chaque jonction 35 située à l'extérieur de la deuxième zone dans sa deuxième configuration.

Les étapes 200 à 230 sont notamment répétées successivement dans l'ordre détaillé précédemment de manière à faire pivoter le contour fermé 85 de 360 degrés (°) ou plus, selon le nombre d'itérations des étapes 200 à 230. En particulier, les étapes 200 à 230 sont répétées de manière à obtenir une rotation périodique du contour fermé avec une vitesse de rotation comprise entre 100 degrés par seconde et 10 000 degrés par seconde. Toutefois, la vitesse de rotation est susceptible de varier.

Le basculement d'une jonction 35 de la première à la deuxième configuration ne modifie pas significativement la résistance électrique de la jonction, de sorte que la tension électrique entre les conducteurs d'extrémité 30A n'est pas modifiée par la rotation du contour 85. Toutefois, la tension électrique entre ces deux conducteurs 30A dépend de l'homogénéité du champ magnétique perçu par les différents SQUIDs formés par les jonctions 35 qui sont dans leurs premières configurations. En particulier, la différence (en valeur absolue) entre la valeur de la tension électrique en présence d'un champ magnétique, par exemple du champ magnétique d'une onde électromagnétique radiofréquence, et la valeur de la tension électrique en l'absence de ce champ magnétique est d'autant plus importante que le champ magnétique est homogène sur les différents SQUIDs.

Ainsi, lorsque le contour fermé 85 est tel que la dimension maximale est mesurée selon une direction perpendiculaire à la direction de propagation de l'onde électromagnétique, la variation de la tension causée par l'onde électromagnétique est maximale, alors qu'elle est minimale lorsque c'est la dimension minimale qui est mesurée selon une direction perpendiculaire à la direction de propagation. Ainsi, lorsque le système 10 est une antenne, le système 10 est propre à déterminer la direction de propagation d'une onde électromagnétique reçue par le dispositif 15.

En outre, la vitesse de rotation du contour fermé 85 est susceptible d'être très supérieure aux vitesses de rotation des antennes de l'état de la technique dans lesquelles l'antenne, éventuellement comprenant un ou plusieurs SQUIDs, est mécaniquement mise en rotation.

Des exemples de jonctions 35 présentant une première configuration et une deuxième configuration sont donnés ci-après. Chacun de ces exemples de jonction 35 est susceptible d'être utilisé dans un dispositif 15 tel que défini précédemment.

Des exemples d'organe de contrôle 40 propres à faire commuter les différents exemples de jonctions 35 sont également décrits.

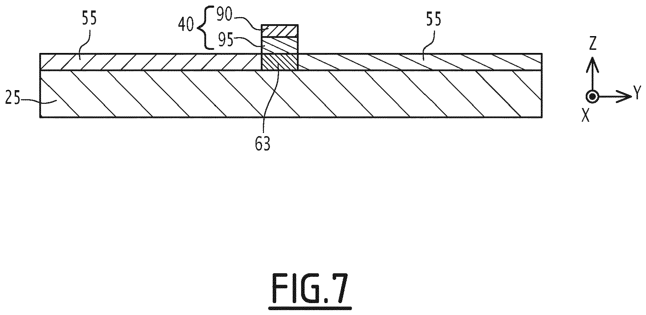

Un premier exemple de jonction 35 est représenté sur la figure 7.

La barrière 63 est réalisée en un deuxième matériau, qui est par exemple supraconducteur. Par exemple, la barrière 63 est réalisée en le premier matériau M1.

La barrière 63 est électriquement connectée aux deux deuxièmes portions 55 qui relient la jonction 35 aux premières portions 50 des conducteurs 30A, 30B entre lesquels la jonction 35 est interposée.

L'organe de contrôle 40 comprend une couche ferroélectrique 90 et une deuxième électrode 95.

La couche ferroélectrique 90 est en contact avec la barrière 63. Par exemple, la couche ferroélectrique 90 et la barrière 63 sont superposées selon une direction d'empilement qui est notamment la direction normale Z, comme représenté sur la figure 7. Toutefois, la direction d'empilement est susceptible de varier.

La couche ferroélectrique 90 est réalisée en un troisième matériau M3.

Il est défini, pour le troisième matériau M3, une polarisation électrique PE. Cela signifie que le troisième matériau M3 présente une pluralité de dipôles électriques générant chacun un moment électrique, et la polarisation électrique PE est définie comme étant la moyenne, par unité de volume, des moments électriques. La polarisation électrique PE est donc une grandeur vectorielle.

Le troisième matériau M3 est un matériau ferroélectrique.

Cela signifie que la polarisation PE est non nulle en l'absence de champ électrique extérieur. En d'autres termes, le barycentre des charges positives et le barycentre des charges négatives dans la barrière 63 ne sont pas confondus, même en l'absence de champ électrique extérieur.

La polarisation PE est mobile entre une première orientation O1 et une deuxième orientation O2.

Lorsque la polarisation PE est dans la première orientation O1, la polarisation PE présente au moins une composante parallèle à la direction d'empilement. Cela signifie que la première orientation O1 n'est pas perpendiculaire à la direction d'empilement.

Lorsque la polarisation PE est dans la deuxième orientation O2, la polarisation PE présente au moins une composante parallèle à la direction d'empilement. La composante est de sens opposé au sens de la première orientation O1.

De préférence, la première orientation O1 est parallèle à la direction d'empilement.

Par exemple, lorsque la polarisation PE est dans la première orientation O1, la polarisation PE est dirigée vers la barrière 63.

La couche ferroélectrique 90 est notamment interposée entre la barrière 63 et la deuxième électrode 95. Par exemple, la couche ferroélectrique 90 est délimitée selon la direction d'empilement par la barrière 63 et par la deuxième électrode 95. En variante, une ou plusieurs couches additionnelles sont susceptibles d'être interposées entre la couche ferroélectrique 90 et l'une ou l'autre de la barrière 63 et de la deuxième électrode 95.

L'organe de contrôle 40 est, notamment, configuré pour contrôler la direction de la polarisation PE de la couche ferroélectrique 90.

Par exemple, l'organe de contrôle 40 est propre à contrôler la direction de la polarisation PE via une impulsion de tension entre la deuxième électrode 95 et l'une des premières électrodes 57. Cela signifie que l'organe de contrôle 40 est configuré pour imposer, pendant une durée temporelle prédéterminée, une différence de potentiel V2 entre les deux faces de la couche ferroélectrique 90 qui délimitent cette couche 90 selon la direction d'empilement.

Par exemple, l'organe de contrôle 40 est configuré pour générer un courant électrique entre une première électrode 57 et la deuxième électrode 95.

L'impulsion de tension modifie l'orientation de la polarisation électrique PE de la couche ferroélectrique 90.

Par exemple, lorsque le signe de la différence de potentiel V2 est positif, la polarisation PE est pivotée depuis la première orientation O1 jusqu'à la deuxième orientation O2. Au contraire, lorsque le signe de la différence de potentiel V2 est négatif, la polarisation PE est pivotée depuis la deuxième orientation O2 jusqu'à la première orientation O1.

La polarisation PE provoque l'accumulation de charges électriques dans la barrière 63 lorsque la polarisation PE est dans la première orientation O1.

L'accumulation de charge diminue la température critique de la barrière 63 depuis une première valeur T1 strictement supérieure à la température de consigne Tc jusqu'à une deuxième valeur T2 strictement inférieure à la température de consigne Tc.

La deuxième valeur T2 étant strictement inférieure à la température de consigne Tc, la barrière 63 n'est donc pas supraconductrice lorsque la polarisation PE est dans la deuxième orientation O2.

Au contraire, lorsque la polarisation PE est dans la première orientation O2, la polarisation PE ne provoque pas d'accumulation de charges dans la barrière 63. La barrière 63 est donc supraconductrice.

Ainsi, l'organe de contrôle 40 est propre à modifier les caractéristiques de la barrière 63 selon que la barrière 63 est supraconductrice ou non à la température de consigne Tc.

En particulier, les valeurs de température critique et/ou de courant critique de la jonction 35 sont différentes selon que la barrière 63 est supraconductrice ou non. Notamment, la température critique et/ou le courant critique présente(nt) chacun une valeur strictement inférieure lorsque la barrière 63 n'est pas supraconductrice que lorsque la barrière 63 est supraconductrice. Ainsi, la jonction 35 forme une jonction Josephson lorsque la barrière 63 est supraconductrice et empêche le passage de paires de Cooper entre les deux portions 55 lorsque la barrière 63 n'est pas supraconductrice.

Ce premier exemple de jonction 35 ne nécessite pas l'application d'une tension pour rester dans l'une ou l'autre de ses configurations, et permet une commutation rapide.

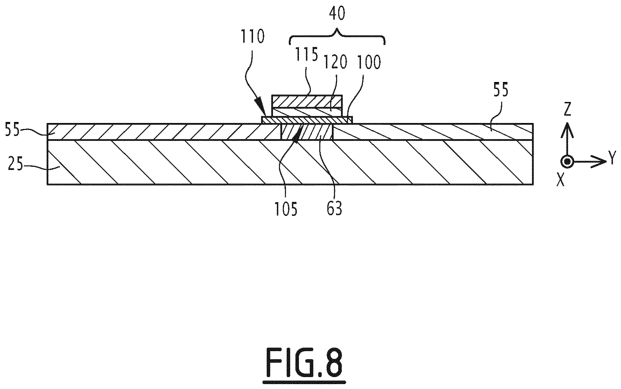

Un deuxième exemple de jonction 35 et d'un organe de contrôle 40 associé est représenté sur la figure 8.

La jonction 35 comprend, outre la barrière 63, une couche électriquement conductrice 100.

La barrière 63 est réalisée en un matériau non-supraconducteur. Par exemple, la barrière 63 est réalisée en un matériau électriquement isolant. Selon un mode de réalisation, la barrière 63 est réalisée en un matériau obtenu par irradiation de premier matériau M1 avec un faisceau d'ions. Par exemple, un tel matériau est obtenu par irradiation de YBCO avec des ions oxygène ou hélium.

La barrière 63 présente une largeur, mesurée selon la direction Y, comprise entre 500 nm et 5 µm. En particulier, la barrière 63 empêche le passage de paires de Cooper entre les deuxièmes portions 55. La barrière 63 est notamment en contact avec les deux deuxièmes portions 55 auxquelles la jonction 35 est connectée.

La couche électriquement conductrice 100 est perpendiculaire à une direction d'empilement, qui est par exemple la direction normale Z, bien que d'autres directions soient envisageables.

La couche électriquement conductrice 100 est, par exemple, réalisée en graphène. Toutefois, d'autres matériaux électriquement conducteurs sont également envisageables, notamment des matériaux présentant des cônes de Dirac dans leur structure de bande.

La couche électriquement conductrice 100 présente une épaisseur inférieure ou égale à 5 nm. En particulier, la couche électriquement conductrice 100 est une couche monoatomique.

La couche électriquement conductrice 100 présente une première face 105 et une deuxième face 110.

La première face 105 est en contact avec la barrière 63. En particulier, la première face 105 est en contact conjointement avec la barrière 63 et avec les deux portions 55, en particulier avec les extrémités des deux portions 55.

La première face 105 est plane, notamment perpendiculaire à la direction d'empilement.

La deuxième face 110 est opposée à la première face 105. En particulier, la couche 100 est délimitée par la première face 105 et la deuxième face 110 selon la direction d'empilement.

L'organe de contrôle 40 comporte une électrode de configuration 115 et une couche barrière 120.

L'électrode de configuration 115 est réalisée en un matériau électriquement conducteur, par exemple l'or.

La couche barrière 120 est interposée entre l'électrode de configuration 115 et la couche électriquement conductrice 100. En particulier, la couche barrière 120 est en contact avec la deuxième face 110.

La couche barrière 120 est interposée entre l'électrode de configuration 115 et la couche 100. La couche barrière 120 est réalisée en un matériau électriquement isolant, par exemple en oxyde d'aluminium.

L'organe de contrôle 40 est configuré pour modifier un potentiel électrique de l'électrode de configuration 120. En particulier, l'organe de contrôle 40 est configuré pour modifier un potentiel électrique de l'électrode de configuration 120 entre une troisième valeur et une quatrième valeur.

La commutation du potentiel électrique de l'électrode 120 entre les troisième et quatrième valeurs déplace le niveau de Fermi de la couche électriquement conductrice 100 entre une cinquième valeur et une sixième valeur.

Lorsque le niveau de Fermi présente la cinquième valeur, le passage de paires de Cooper à travers la couche électriquement conductrice 100 est possible, alors que ce passage n'est pas permis lorsque le niveau de Fermi présente la sixième valeur.

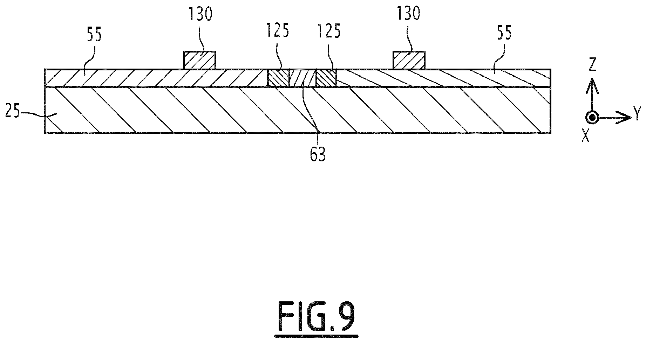

Un troisième exemple de jonction 35 est représenté sur la figure 9, avec une partie d'un organe de contrôle 40 associé.

La jonction 35 comporte, outre la barrière 63, au moins deux couches magnétiques 125. La jonction 35 est propre à permettre à un courant électrique de circuler depuis l'une des deuxièmes portions 55 correspondantes jusqu'à l'autre deuxième portion 55, le courant électrique traversant la barrière 63 et les deux couches magnétiques 125.

Les couches magnétiques 125 encadrent, par exemple, la barrière 63 selon la deuxième direction Y. En particulier, chaque couche magnétique 125 est interposée entre la barrière 63 et l'une des deuxièmes portions 55 correspondantes.

La barrière 63 présente une épaisseur comprise entre 0.5 nm et 10 nm.

La barrière 63 est propre à être traversée, par effet tunnel ou par conduction électrique, par des paires de Cooper. Toutefois, la barrière 63 n'est pas réalisée en un matériau supraconducteur.

Par exemple, la barrière 63 est réalisée en cuivre.

Chaque couche 125 est réalisée en un matériau magnétique.

En particulier, le terme « matériau magnétique » sera utilisé pour un matériau ferromagnétique ou un matériau ferrimagnétique.

Dans un matériau ferromagnétique, les moments magnétiques sont orientés parallèlement les uns aux autres. Lorsqu'un matériau ferromagnétique est soumis à un champ magnétique extérieur, les moments magnétiques du matériau s'orientent, en restant parallèles les uns aux autres, dans la direction du champ magnétique extérieur.

Dans un matériau ferrimagnétique, les moments magnétiques sont orientés antiparallèlement les uns aux autres, sans pour autant se compenser parfaitement.

La résultante des moments dans un matériau ferrimagnétique est strictement inférieure à la résultante des moments dans ce même matériau, s'il était ferromagnétique. Lorsqu'un matériau ferrimagnétique est soumis à un champ magnétique extérieur, les moments magnétiques du matériau s'orientent, tout en restant antiparallèles les uns aux autres, de telle sorte que la résultante soit orientée dans la direction du champ magnétique extérieur.

Le nickel Ni et le permalloy NiFe sont des exemples de matériaux magnétiques.

Chaque couche (125) est, par exemple, perpendiculaire à la direction Y.

Chaque couche magnétique 125 présente une épaisseur, mesurée selon la deuxième direction Y, comprise entre 0.5 nm et 2.5 nm.

L'organe de contrôle 40 est propre à modifier, de manière connue, la direction d'aimantation d'au moins une des couches magnétiques 125. Par exemple, la direction d'aimantation de l'une des couches magnétiques 125 est fixe tandis que la direction d'aimantation de l'autre couche magnétique 125 est mobile.

Chaque direction d'aimantation est, par exemple, perpendiculaire à la deuxième direction Y.

Par exemple, l'organe de contrôle 40 comprend au moins une électrode de configuration 130, par exemple deux électrodes de configuration 130. L'organe de contrôle 40 est configuré pour générer un courant électrique traversant l'électrode de configuration, l'une des couches magnétiques 125, la barrière 63 et l'autre couche magnétique 125. Par exemple, le courant électrique traverse l'une des électrodes de configuration 130, une partie d'une deuxième portion 55, une couche magnétique 125, la barrière 63, l'autre couche magnétique 125, une partie de l'autre deuxième portion 55 formant la jonction 35 et l'autre électrode de configuration 130.

Par effet dit de « transfert de spin », la direction variable d'aimantation de l'une des couches magnétiques 125 pivote autour d'un axe parallèle à la deuxième direction Y. Ainsi, la direction variable d'aimantation est modifiée. En particulier, un angle entre les directions d'aimantation des deux couches magnétiques 125 est modifié. Ainsi, l'organe de contrôle 40 est propre à modifier un angle entre les directions d'aimantation par génération d'un courant électrique.

Lorsqu'un courant traverse la jonction 35, notamment un courant circulant entre les deux conducteurs d'extrémité 30A, les électrons traversant les couches magnétiques 125 subissent une force magnétique qui agit sur les paires de Cooper. En particulier, le déphasage des paires de Cooper dépend de l'angle entre les directions d'aimantation. Le courant critique de la jonction 35 est fonction (en particulier sinusoïdale) de ce déphasage.

Ainsi, le courant critique de la jonction 35 dépend de l'angle entre les directions d'aimantation des deux couches magnétiques 125. Lorsque les directions d'aimantation des deux couches 125 sont identiques, le courant critique de la jonction 35 présente une valeur strictement inférieure à la valeur de la même grandeur lorsque les directions d'aimantation sont opposées.

Ainsi, lorsque les directions d'aimantation des deux couches 125 sont opposées, la jonction 35 forme une jonction Josephson alors que la jonction 35 ne présente pas l'effet Josephson lorsque les directions d'aimantation sont opposées.

Un quatrième exemple de barrière 35 et d'organe de contrôle 40 va maintenant être décrit.

La barrière 63 comprend une portion réalisée en un matériau supraconducteur cuprate.

L'organe de contrôle 40 comporte une électrode de configuration en contact avec la barrière 63.

L'électrode de configuration est réalisée en un matériau électronégatif métallique, par exemple MoSi.

L'organe de contrôle 40 est propre à contrôler un potentiel électrique de l'électrode de configuration.

L'électrode de configuration, étant électronégative, génère des lacunes oxygènes dans la barrière 63. Une lacune oxygène est un emplacement du réseau cristallin de la barrière 63 qui devrait être occupé par un atome d'oxygène mais qui est inoccupé parce que les atomes d'oxygène sont attirés par l'électrode, dont une partie est oxydée par ces atomes.

La température critique des cuprates est une fonction de la quantité d'oxygène qu'ils contiennent. En particulier, plus le taux de lacunes oxygène est élevé, plus la température critique de la jonction 35 diminue. Ainsi, la température critique Tc de la barrière 63 dépend du potentiel électrique de l'électrode de configuration. La jonction 35 commute alors entre ses deux configurations selon que le potentiel électrique correspond à une température critique Tc supérieure ou inférieure à la température à laquelle la jonction 35 se trouve.

L'invention est définie par les revendications.

## Revendications

1. Dispositif (15) comportant un substrat (25), un ensemble de conducteurs électriques (30A, 30B) portés par une face (45) du substrat (25), un ensemble de jonctions (35) portées par ladite face (45) du substrat (25) et un ensemble d'organes de contrôle (40),
chaque conducteur électrique (30A, 30B) étant réalisé en un matériau supraconducteur, chaque conducteur électrique (30A, 30B) comprenant une unique première portion (50) s'étendant selon une première direction (X) tangentielle au substrat (25) et un ensemble de deuxièmes portions (55), les premières portions (50) des conducteurs électriques (30A, 30B) étant décalées successivement les unes par rapport aux autres selon une deuxième direction (Y) perpendiculaire à la première direction (X),
au moins trois jonctions (35) étant interposées selon la deuxième direction (Y) entre chaque paire de premières portions (50) successives, chaque jonction (35) étant reliée à la première portion (50) de chacun des conducteurs (30A, 30B) entre lesquels la jonction (35) est interposée par une deuxième portion (55) dudit conducteur (30A, 30B),
**caractérisé en ce que** chaque organe de contrôle (40) est associé à une unique jonction (35) parmi l'ensemble de jonctions (35), et est configuré pour commuter la jonction (35) associée entre une première configuration dans laquelle la jonction (35) forme une jonction Josephson entre les conducteurs (30A, 30B) auxquels la jonction (35) est reliée et une deuxième configuration dans laquelle la jonction (35) empêche le passage de paires de Cooper entre lesdits conducteurs (30A, 30B).

2. Dispositif selon la revendication 1, comportant au moins dix conducteurs électriques (30A, 30B), au moins dix jonctions (35) étant interposées entre chaque paire de premières portions (50) successives.

3. Dispositif selon la revendication 1 ou 2, dans lequel chaque deuxième portion (55) s'étend selon la deuxième direction (Y).

4. Dispositif selon l'une quelconque des revendications précédentes, dans lequel chaque jonction (35) comporte une barrière (63) formant une barrière entre les deux deuxièmes portions (55) reliées à la jonction (35), au moins une des propriétés suivantes étant vérifiée :
- la barrière (63) est réalisée en un matériau ferroélectrique présentant une polarisation électrique, l'organe de contrôle (40) étant configuré pour modifier une direction de la polarisation électrique ;
- la barrière (63) est réalisée en un matériau électriquement isolant, la jonction (35) comportant, en outre, une couche électriquement conductrice (100) présentant une première face (105) en contact avec les deux deuxièmes portions (55) et une deuxième face (110) opposée à la première face (105), l'organe de contrôle (40) comportant une couche barrière (120) électriquement isolante en contact avec la deuxième face (110) et une électrode de configuration (115), la couche barrière (120) étant interposée entre la couche électriquement conductrice (100) et l'électrode de configuration (115), l'organe de contrôle (40) étant configuré pour modifier un potentiel électrique de l'électrode de configuration (115), la couche électriquement conductrice (100) étant notamment réalisée en graphène ;
- la jonction (35) comporte au moins deux couches (125) magnétiques, chaque couche magnétique (125) étant réalisée en un matériau magnétique, la jonction (35) étant configurée pour être traversée par un courant électrique traversant la barrière (63) et les deux couches magnétiques (125), l'organe de contrôle (40) étant configuré pour modifier une orientation d'une aimantation d'au moins une des couches magnétiques (125).

5. Dispositif selon l'une quelconque des revendications précédentes, comportant, en outre, une électrode de sortie (57), une électrode d'entrée (57), une alimentation électrique (42) et un capteur (43), l'alimentation (42) étant propre à injecter un courant électrique dans l'électrode d'entrée (57) et à fixer une intensité du courant électrique à une valeur prédéterminée, le courant électrique traversant chacun des conducteurs (30A, 30B) depuis l'électrode d'entrée (57) jusqu'à l'électrode de sortie (57), le capteur (43) étant propre à mesurer une différence de potentiel électrique entre l'électrode d'entrée (57) et l'électrode de sortie (57).

6. Dispositif selon l'une quelconque des revendications précédentes, dans lequel chaque première ou deuxième portion (50, 55) est rectiligne.

7. Dispositif selon l'une quelconque des revendications précédentes, dans lequel :
- une distance, mesurée selon la deuxième direction (Y) entre les deux premières portions (50) d'une paire de conducteurs (30A, 30B) successifs, est identique pour chaque paire de conducteurs (30A, 30B) successifs, et/ou
- une distance, mesurée selon la première direction (X) entre deux deuxièmes portions (55) successives d'un même conducteur électrique (30A, 30B), est identique pour chaque paire de deuxièmes portions (55) successives.

8. Système (10) comportant un module de contrôle (20) et un dispositif (15) selon l'une quelconque des revendications précédentes, le système (10) étant notamment une antenne.

9. Système selon la revendication précédente, dans lequel le module de contrôle (20) est configuré pour :
- déterminer (210) un contour fermé (85) sur la face (45) du substrat (25) portant les conducteurs (30A, 30B) et les jonctions (35), le contour fermé (85) délimitant une première zone de ladite face (45),
- commander une commutation (200) de chaque jonction (35) comprise dans la première zone vers la première configuration correspondante et une commutation de chaque jonction (35) située hors de la première zone vers la deuxième configuration correspondante,
- faire pivoter (220) le contour fermé (85) d'un angle prédéterminé autour d'un axe perpendiculaire à la face (45) du substrat (25) portant les conducteurs (30A, 30B) et les jonctions (35), le contour fermé (85) délimitant une deuxième zone à l'issue du pivotement et
- commander une commutation (230) de chaque jonction (35) comprise dans la deuxième zone vers la première configuration correspondante et une commutation de chaque jonction (35) située hors de la deuxième zone vers la deuxième configuration correspondante.

10. Procédé d'utilisation d'un dispositif (15) comportant un substrat (25), un ensemble de conducteurs électriques (30A, 30B) portés par le substrat (25), un ensemble de jonctions (35) et un ensemble d'organes de contrôle (40), chaque conducteur électrique (30A, 30B) étant réalisé en un matériau supraconducteur, chaque conducteur électrique (30A, 30B) comprenant une unique première portion (50) s'étendant selon une première direction (X) tangentielle au substrat (25) et un ensemble de deuxièmes portions (55), les premières portions (50) des conducteurs électriques (30A, 30B) étant décalées successivement les unes par rapport aux autres selon une deuxième direction (Y) perpendiculaire à la première direction (X), au moins trois jonctions (35) étant interposées selon la deuxième direction (Y) entre chaque paire de premières portions (50) successives, chaque jonction (35) étant reliée à la première portion (50) de chacun des conducteurs (30A, 30B) entre lesquels la jonction (35) est interposée par une deuxième portion (55) dudit conducteur,
**caractérisé en ce que** le procédé comporte une étape de commutation (200) d'au moins une jonction (35) entre une première configuration dans laquelle la jonction (35) forme une jonction Josephson entre les conducteurs (30A, 30B) auxquels la jonction (35) est reliée et une deuxième configuration dans laquelle la jonction (35) empêche le passage de paires de Cooper entre lesdits conducteurs (30A, 30B).

11. Procédé selon la revendication précédente, dans lequel, à l'issue de l'étape de commutation (200), chaque jonction (35) comprise dans une première zone de la face (45) du substrat portant les conducteurs (30A, 30B) et les jonctions (35) est dans la première configuration, la première zone étant délimitée par un contour fermé (85) sur ladite face (45), chaque jonction (35) disposée à l'extérieur de la première zone étant dans la deuxième configuration, le procédé comportant, en outre, les étapes suivantes :
- pivotement (220) du contour fermé (85) d'un angle prédéterminé autour d'un axe perpendiculaire à la face (45) du substrat (25) portant les conducteurs (30A, 30B) et les jonctions (35), le contour fermé (85) délimitant sur ladite face (45) une deuxième zone après l'étape de pivotement (220), et
- commutation (230) de chaque jonction (35) comprise dans la deuxième zone vers la première configuration correspondante et commutation de chaque jonction (35) située hors de la deuxième zone vers la deuxième configuration correspondante.

## Patentansprüche

1. Vorrichtung (15) mit einem Substrat (25), einer Gruppe von elektrischen Leitern (30A, 30B), die von einer Seite (45) des Substrats (25) getragen werden, einer Gruppe von Übergängen (35), die von der genannten Seite (45) des Substrats (25) getragen werden, und einer Gruppe von Kontrollorganen (40),
wobei jeder elektrische Leiter (30A, 30B) aus einem supraleitenden Material hergestellt ist, wobei jeder elektrische Leiter (30A, 30B) einen einzigen ersten Abschnitt (50), der sich in einer ersten Richtung (X) tangential zum Substrat (25) erstreckt, und eine Gruppe von zweiten Abschnitten (55) umfasst, wobei die ersten Abschnitte (50) der elektrischen Leiter (30A, 30B) nacheinander in Bezug aufeinander in einer zweiten Richtung (Y) senkrecht zur ersten Richtung (X) versetzt sind,
wobei mindestens drei Übergänge (35) entlang der zweiten Richtung (Y) zwischen jedem Paar von aufeinanderfolgenden ersten Abschnitten (50) angeordnet sind, wobei jeder Übergang (35) mit dem ersten Abschnitt (50) jedes der Leiter (30A, 30B) verbunden ist, zwischen denen der Übergang (35), durch einen zweiten Abschnitt (55) des Leiters (30A, 30B) eingefügt ist,
**dadurch gekennzeichnet, dass** jedes Steuerelement (40) einem einzelnen Übergang (35) aus der Gruppe von Übergängen (35) zugeordnet ist und so konfiguriert ist, dass es den zugeordneten Übergang (35) zwischen einer ersten Konfiguration, in der der Übergang (35) einen Josephson-Übergang zwischen den Leitern (30A, 30B) bildet, mit denen der Übergang (35) verbunden ist, und einer zweiten Konfiguration umschaltet, in der der Übergang (35) den Durchgang von Cooper-Paaren zwischen den Leitern (30A, 30B) verhindert.

2. Vorrichtung nach Anspruch 1 mit mindestens zehn elektrischen Leitern (30A, 30B), wobei mindestens zehn Übergänge (35) zwischen jedem Paar aufeinanderfolgender erster Abschnitte (50) eingefügt sind.

3. Vorrichtung nach Anspruch 1 oder 2, wobei sich jeder zweite Abschnitt (55) in der zweiten Richtung (Y) erstreckt.

4. Vorrichtung nach einem der vorhergehenden Ansprüche, wobei jeder Übergang (35) eine Barriere (63) aufweist, die eine Sperre zwischen den beiden zweiten Abschnitten (55) bildet, die mit dem Übergang (35) verbunden sind, wobei mindestens eine der folgenden Eigenschaften überprüft wird:
- die Barriere (63) ist aus einem ferroelektrischen Material mit einer elektrischen Polarisation hergestellt, wobei das Steuerelement (40) so konfiguriert ist, dass es eine Richtung der elektrischen Polarisation ändert;
- die Barriere besteht (63) aus einem elektrisch isolierenden Material, der Übergang (35) weist außerdem eine elektrisch leitende Schicht (100) mit einer ersten Seite (105) auf, die mit den beiden zweiten Bereichen (55) in Kontakt steht, und eine zweite Seite (110), die der ersten Seite (105) gegenüberliegt, wobei das Steuerelement (40) eine elektrisch isolierende Sperrschicht (120) aufweist, die mit der zweiten Seite (110) in Kontakt ist, und eine Musterelektrode (115), wobei die Sperrschicht (120) zwischen der elektrisch leitenden Schicht (100) und der Musterelektrode (115) angeordnet ist, wobei das Steuerelement (40) so konfiguriert ist, dass es ein elektrisches Potential der Musterelektrode (115) ändert, wobei die elektrisch leitfähige Schicht (100) insbesondere aus Graphen gefertigt ist;
- wobei der Übergang (35) mindestens zwei magnetische Schichten (125) aufweist, wobei jede magnetische Schicht (125) aus einem magnetischen Material besteht, der Übergang (35) so konfiguriert ist, dass er von einem elektrischen Strom durchflossen wird, der durch die Barriere (63) und die beiden magnetischen Schichten (125) fließt, wobei das Steuerelement (40) so konfiguriert ist, dass es eine Ausrichtung einer Magnetisierung von mindestens einer der magnetischen Schichten (125) ändert.

5. Vorrichtung nach einem der vorhergehenden Ansprüche, die außerdem eine Ausgangselektrode (57), eine Eingangselektrode (57), eine elektrische Stromversorgung (42) und einen Sensor (43) umfasst, wobei die Stromversorgung (42) geeignet ist, einen elektrischen Strom in die Eingangselektrode (57) zu injizieren und eine Stromstärke des elektrischen Stroms auf einen vorbestimmten Wert zu bringen, wobei der elektrische Strom durch jeden der Leiter (30A, 30B) von der Eingangselektrode (57) zu der Ausgangselektrode (57) fließt, wobei der Sensor (43) dazu geeignet ist, eine elektrische Potentialdifferenz zwischen der Eingangselektrode (57) und der Ausgangselektrode (57) zu messen.

6. Vorrichtung nach einem der vorhergehenden Ansprüche, bei der jeder erste oder zweite Abschnitt (50, 55) geradlinig ist.

7. Vorrichtung nach einem der vorherigen Ansprüche, wobei:
- ein Abstand, gemessen in der zweiten Richtung (Y) zwischen den beiden ersten Abschnitten (50) eines Paars aufeinanderfolgender Leiter (30A, 30B), für jedes Paar aufeinanderfolgender Leiter (30A, 30B) gleich ist, und/oder
- ein Abstand, gemessen in der ersten Richtung (X) zwischen zwei aufeinanderfolgenden zweiten Abschnitten (55) eines gleichen elektrischen Leiters (30A, 30B), für jedes Paar von aufeinanderfolgenden zweiten Abschnitten (55) gleich ist.

8. System (10) mit einem Steuermodul (20) und einer Vorrichtung (15) nach einem der vorhergehenden Ansprüche, wobei das System (10) insbesondere eine Antenne ist.

9. System nach dem vorhergehenden Anspruch, wobei das Steuermodul (20) zu Folgendem konfiguriert ist:
- Bestimmen (210) einer geschlossenen Kontur (85) auf der Fläche (45) des Substrats (25), die die Leiter (30A, 30B) und die Übergänge (35) trägt, wobei die geschlossene Kontur (85) einen ersten Bereich der Fläche (45) begrenzt,
- Steuern eines Umschaltens (200) jedes Übergangs (35), der in dem ersten Bereich enthalten ist, auf die entsprechende erste Konfiguration und eines Umschaltens jedes Übergangs (35), der sich außerhalb des ersten Bereichs befindet, auf die entsprechende zweite Konfiguration,
- Schwenken (220) der geschlossenen Kontur (85) um einen vorbestimmten Winkel um eine Achse senkrecht zu der Seite (45) des Substrats (25), die die Leiter (30A, 30B) und die Übergänge (35) trägt, wobei die geschlossene Kontur (85) nach dem Schwenken einen zweiten Bereich begrenzt, und
- Steuern eines Umschaltens (230) jedes Übergangs (35), der in dem zweiten Bereich enthalten ist, auf die entsprechende erste Konfiguration und eines Umschaltens jedes Übergangs (35), der sich außerhalb des zweiten Bereichs befindet, auf die entsprechende zweite Konfiguration.

10. Verfahren zur Verwendung einer Vorrichtung (15), die ein Substrat (25), eine Gruppe von elektrischen Leitern (30A, 30B), die von einem Substrat (25) getragen werden, eine Gruppe von Übergängen (35) und eine Gruppe von Steuerelementen (40) umfasst, wobei jeder elektrische Leiter (30A, 30B) aus einem supraleitenden Material hergestellt ist, wobei jeder elektrische Leiter (30A, 30B) einen einzigen ersten Abschnitt (50), der sich in einer ersten Richtung (X) tangential zum Substrat (25) erstreckt, und einen Satz von zweiten Abschnitten (55) umfasst, wobei die ersten Abschnitte (50) der elektrischen Leiter (30A, 30B) aufeinanderfolgend in Bezug zueinander in einer zweiten Richtung (Y) senkrecht zur ersten Richtung (X) versetzt sind, wobei mindestens drei Übergänge (35) in der zweiten Richtung (Y) zwischen jedem Paar aufeinanderfolgender erster Abschnitte (50) angeordnet sind, wobei jeder Übergang (35) mit dem ersten Abschnitt (50) jedes der Leiter (30A, 30B) zwischen denen der Übergang (35) durch einen zweiten Abschnitt (55) des Leiters eingefügt ist, **dadurch gekennzeichnet dass** das Verfahren einen Schritt des Umschaltens (200) mindestens einer Verbindung (35) zwischen einer ersten Konfiguration, in der die Verbindung (35) eine Josephson-Verbindung zwischen den Leitern (30A, 30B) bildet, mit denen die Verbindung (35) verbunden ist, und einer zweiten Konfiguration umfasst, in der die Verbindung (35) den Durchgang von Cooper-Paaren zwischen den Leitern (30A, 30B) verhindert.

11. Verfahren nach dem vorhergehenden Anspruch, bei dem am Ende des Schaltschritts (200) jeder Übergang (35), der in einem ersten Bereich der Seite (45) des Substrats enthalten ist, die die Leiter (30A, 30B) und die Übergänge (35) trägt, in der ersten Konfiguration ist, wobei der erste Bereich durch eine geschlossene Kontur (85) auf der Fläche (45) begrenzt ist, wobei jeder Übergang (35), der außerhalb des ersten Bereichs angeordnet ist, in der zweiten Konfiguration ist, wobei das Verfahren ferner die folgenden Schritte umfasst:
- Schwenken (220) der geschlossenen Kontur (85) um einen vorgegebenen Winkel um eine Achse senkrecht zur der Seite (45) des Substrats (25), die die Leiter (30A, 30B) und die Übergänge (35) trägt, wobei die geschlossene Kontur (85) auf der Seite (45) nach dem Schritt des Schwenkens (220) einen zweiten Bereich begrenzt, und
- Umschalten (230) jedes Übergangs (35), der in dem zweiten Bereich enthalten ist, auf die entsprechende erste Konfiguration und Umschalten jedes Übergangs (35), der sich außerhalb des zweiten Bereichs befindet, auf die entsprechende zweite Konfiguration.

## Claims

1. A device (15) including a substrate (25), a set of electrical conductors (30A, 30B) carried by a face (45) of the substrate (25), a set of junctions (35) carried by said face (45) of the substrate (25) and a set of control elements (40),
each electrical conductor (30A, 30B) being made of a superconducting material, each electrical conductor (30A, 30B) comprising a single first portion (50) extending in a first direction (X) tangential to the substrate (25) and a set of second portions (55), the first portions (50) of the electrical conductors (30A, 30B) being successively offset relative to each other according to a second direction (Y) perpendicular to the first direction (X),
at least three junctions (35) being interposed according to the second direction (Y) between each pair of successive first portions (50), each junction (35) being connected to the first portion (50) of each of the conductors (30A, 30B) between which the junction (35) is interposed by a second portion (55) of said conductor (30A, 30B),
**characterized in that** each control element (40) is associated with a single junction (35) of the set of junctions (35), and is configured to switch the associated junction (35) between a first configuration in which the junction (35) forms a Josephson junction between the conductors (30A, 30B) to which the junction (35) is connected and a second configuration in which the junction (35) prevents the passage of Cooper pairs between said conductors (30A, 30B).

2. The device according to claim 1, including at least ten electrical conductors (30A, 30B), at least ten junctions (35) being interposed between each pair of successive first portions (50).

3. The device according to claim 1 or 2, wherein each second portion (55) extends according to the second direction (Y).

4. The device according to any of the preceding claims, wherein each junction (35) includes a barrier (63) forming a barrier between the two second portions (55) connected to the junction (35), at least one of the following properties being verified:
- the barrier (63) is made of a ferroelectric material presenting an electrical polarization, the control element (40) being configured to modify a direction of the electrical polarization;
- the barrier (63) is made of an electrically insulating material, the junction (35) further including an electrically conductive layer (100) presenting a first face (105) in contact with the two second portions (55) and a second face (110) opposite the first face (105), the control element (40) including an electrically insulating barrier layer (120) in contact with the second face (110) and a configuration electrode (115) the barrier layer (120) being interposed between the electrically conductive layer (100) and the configuration electrode (115), the control element (40) being configured to modify an electrical potential of the configuration electrode (115), the electrically conductive layer (100) being made in particular of graphene;
- the junction (35) includes at least two magnetic layers (125), each magnetic layer (125) being made of a magnetic material, the junction (35) being configured to have an electric current flowing through the barrier (63) and the two magnetic layers (125), the control element (40) being configured to modify an orientation of a magnetization of at least one of the magnetic layers (125).

5. The device according to any one of the preceding claims, further including an output electrode (57), an input electrode (57), a power supply (42), and a sensor (43), the power supply (42) being able to inject an electric current into the input electrode (57) and to set a magnitude of the electric current at a predetermined value, the electric current flowing through each of the conductors (30A, 30B) from the input electrode (57) to the output electrode (57), the sensor (43) being able to measure an electric potential difference between the input electrode (57) and the output electrode (57).

6. The device according to any one of the preceding claims, wherein each first or second portion (50, 55) is straight.

7. The device according to any one of the preceding claims, wherein:
- a distance, measured according to the second direction (Y) between the two first portions (50) of a pair of successive conductors (30A, 30B), is identical for each pair of successive conductors (30A, 30B), and/or
- a distance, measured according to the first direction (X) between two successive second portions (55) of a same electrical conductor (30A, 30B), is identical for each pair of successive second portions (55).

8. A system (10) including a control module (20) and a device (15) according to any of the preceding claims, the system (10) being in particular an antenna.

9. The system according to the preceding claim, wherein the control module (20) is configured for:
- determining (210) a closed contour (85) on the face (45) of the substrate (25) carrying the conductors (30A, 30B) and the junctions (35), the closed contour (85) delimiting a first zone of said face (45),
- controlling a switching (200) of each junction (35) included in the first zone to the corresponding first configuration and a switching of each junction (35) located outside the first zone to the corresponding second configuration
- rotating (220) the closed contour (85) through a predetermined angle about an axis perpendicular to the face (45) of the substrate (25) carrying the conductors (30A, 30B) and the junctions (35), the closed contour (85) delimiting a second zone upon completion of the rotating, and
- controlling a switching (230) of each junction (35) included in the second zone to the corresponding first configuration and a switching of each junction (35) located outside the second zone to the corresponding second configuration.

10. A method for using a device (15) including a substrate (25), a set of electrical conductors (30A, 30B) carried by the substrate (25), a set of junctions (35) and a set of control elements (40), each electrical conductor (30A, 30B) being made of a superconducting material, each electrical conductor (30A, 30B) comprising a single first portion (50) extending according to a first direction (X) tangential to the substrate (25) and a set of second portions (55) the first portions (50) of the electrical conductors (30A, 30B) being successively offset relative to each other according to a second direction (Y) perpendicular to the first direction (X), at least three junctions (35) being interposed according to the second direction (Y) between each pair of successive first portions (50), each junction (35) being connected to the first portion (50) of each of the conductors (30A, 30B), between which the junction (35) is interposed, by a second portion (55) of said conductor,
**characterized in that** the method includes a step (200) of switching at least one junction (35) between a first configuration in which the junction (35) forms a Josephson junction between the conductors (30A, 30B) to which the junction (35) is connected and a second configuration in which the junction (35) prevents the passage of Cooper pairs between said conductors (30A, 30B).

11. The method according to the preceding claim, in which, at the end of the switching step (200), each junction (35) included in a first zone of the face (45) of the substrate carrying the conductors (30A, 30B) and the junctions (35) is in the first configuration, the first zone being delimited by a closed contour (85) on said face (45), each junction (35) arranged outside the first zone being in the second configuration, the method further comprising the following steps:
- rotating (220) the closed contour (85) through a predetermined angle about an axis perpendicular to the face (45) of the substrate (25) carrying the conductors (30A, 30B) and the junctions (35), the closed contour (85) delimiting a second zone on said face (45) after the rotating step (220), and
- switching (230) each junction (35) within the second zone to the corresponding first configuration and switching each junction (35) outside the second zone to the corresponding second configuration.
